# EUROPEAN PATENT APPLICATION

(11) **EP 2 383 794 A1**
(43) Date of publication of application: **02.11.2011**
(21) Application number: 10733323.9
(22) Date of filing: 14.01.2010
(51) Int. Cl.: H01L 31/04, H01B 1/22

(54) **PASTE COMPOSITION AND SOLAR CELL ELEMENT USING SAME**

(30) Priority: 23.01.2009 JP 2009012613
(71) Applicant: Toyo Aluminium Kabushiki Kaisha, Osaka-shi, Osaka 541-0056 (JP)
(72) Inventor: WATSUJI, Takashi, Osaka-shi Osaka 541-0056 (JP); KIKUCHI, Ken, Osaka-shi Osaka 541-0056 (JP); OCHI, Yutaka, Osaka-shi Osaka 541-0056 (JP); ISHIBASHI, Naoaki, Osaka-shi Osaka 541-0056 (JP)
(74) Representative: Grünecker, Kinkeldey, Stockmair & Schwanhäusser
(86) International application number: PCT/JP2010/000161
(87) International publication number: WO 2010/084715

(57) **Abstract**

Provided are a paste composition capable of avoiding deteriorations in a mechanical strength and an adhesion property of an electrode layer, of sufficiently attaining a desired BSF effect, and of suppressing deformation (bow) of the silicon semiconductor substrate even in a case where a silicon semiconductor substrate is rendered thin; and a solar cell element including an impurity layer, or an impurity layer and an electrode layer, which is (or are) formed by using the above-mentioned composition. The paste composition is used for forming a p⁺ layer (7) or an aluminum electrode layer (5) on a silicon semiconductor substrate (1) and includes an aluminum-coated compound powder. Aluminum-coated compound particles constitute this aluminum-coated compound powder, and each of the aluminum-coated compound particles includes: a compound-particle of at least of one kind of a compound selected from the group consisting of an inorganic compound and an organic compound; and an aluminum-containing coating layer which covers a surface of the compound-particle, is located in an outermost surface of each of the aluminum-coated compound particles, and contains aluminum.

## Description

### TECHNICAL FIELD

The present invention relates generally to paste compositions and solar cell elements using the same. More particularly, the present invention relates to a paste composition, which is used for forming an impurity layer or an electrode on a silicon semiconductor substrate constituting a crystalline silicon solar cell, and to a solar cell element using the same.

### BACKGROUND ART

As electronic components each having an electrode formed on a silicon semiconductor substrate, solar cell elements disclosed in Japanese Patent Application Laid-Open Publication No. 2000-90734 (hereinafter, referred to as Patent Literature 1), Japanese Patent Application Laid-Open Publication No. 2004-134775 (hereinafter, referred to as Patent Literature 2), and Japanese Patent Application Laid-Open Publication No. 2003-223813 (hereinafter, referred to as Patent Literature 3) have been known.

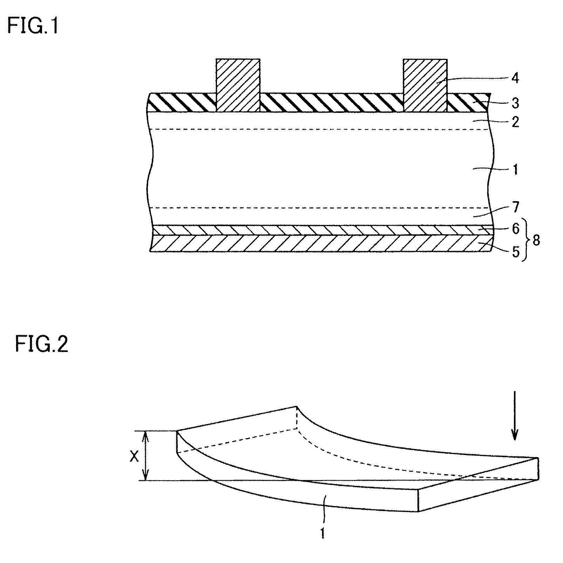

Fig. 1 is a schematic view showing a general sectional structure of a solar cell element.

As shown in Fig. 1, the solar cell element is structured in general by using a p-type silicon semiconductor substrate 1 whose thickness is 150 through 300 µm. On a light receiving surface of the p-type silicon semiconductor substrate 1, an n-type impurity layer 2 whose thickness is 0.3 through 0.6 µm, and an antireflection film 3 and grid electrodes 4, which are on the n-type impurity layer 2, are formed.

On a back surface of the p-type silicon semiconductor substrate 1, an aluminum electrode layer 5 is formed. The formation of the aluminum electrode layer 5 is conducted through applying an aluminum paste composition containing aluminum powder, a glass frit, and an organic vehicle by employing screen printing or the like; conducting drying; and thereafter, firing the aluminum paste composition at a temperature greater than or equal to 660°C (melting point of aluminum). During the firing, the aluminum is diffused inside of the p-type silicon semiconductor substrate 1, whereby an Al-Si alloy layer 6 is formed between the aluminum electrode layer 5 and the p-type silicon semiconductor substrate 1 and concurrently, a p⁺ layer 7 is formed as an impurity layer resulting from diffusion of aluminum atoms. The presence of the p⁺ layer 7 prevents recombination of electrons, and therefore, a BSF (Back Surface Field) effect which enhances an efficiency of collecting generated carriers can be obtained.

In the meantime, in order to reduce costs in manufacturing solar cells and to solve a problem of a shortage of a silicon material, rendering the p-type silicon semiconductor substrate 1 further thinner has been examined these days. However, when the silicon semiconductor substrate 1 is thinner, after firing the aluminum paste composition, a back surface having a back surface electrode 8 formed thereon is deformed in a concave manner due to a difference between thermal expansion coefficients of silicon and aluminum, thereby deforming and bowing the silicon semiconductor substrate 1. Consequently, a fracture or the like in the silicon semiconductor substrate 1 is caused in a process of manufacturing a solar cell. As a result, there has arisen a problem that manufacturing yields of the solar cells are reduced.

There is a method to solve this problem, in which an application amount of the paste composition is decreased and the back surface electrode 8 is rendered thinner. However, when the application amount of the paste composition is decreased, an amount of the aluminum diffused from a surface of the silicon semiconductor substrate 1 to an inside thereof becomes insufficient. As a result, a desired BSF effect cannot be achieved, thereby incurring a problem that properties of a solar cell are deteriorated.

Therefore, composition of an electrically conductive paste which is capable of ensuring desired properties of a solar cell and reducing the bow of the silicon semiconductor substrate 1 is disclosed in, for example, Patent Literature 1. This electrically conductive paste contains an aluminum powder, a glass frit, an organic vehicle, and further an aluminum-containing organic compound.

In addition, Patent Literature 2 discloses a method in which at least one kind of organic compound particles and carbon particles is added to the conventional paste composition and shrinkage of the aluminum electrode layer 5, caused upon firing, is suppressed, thereby reducing the bow of the silicon semiconductor substrate 1. According to this method, the added organic compound particles or carbon particles are present in a state of solid particles in the paste and upon the firing, are burnt to disappear. This causes a multitude of fine pores to be formed inside the electrode, thereby allowing the substrate to be prevented from bowing.

Furthermore, Patent Literature 3 discloses a method in which an inorganic compound powder is added and shrinkage of the aluminum electrode layer 5, caused upon firing, is suppressed, thereby reducing the bow of the silicon semiconductor substrate 1.

### CITATION LIST

### PATENT LITERATURE

[Patent Literature 1] Japanese Patent Application Laid-Open Publication No. 2000-90734
[Patent Literature 2] Japanese Patent Application Laid-Open Publication No. 2004-134775
[Patent Literature 3] Japanese Patent Application Laid-Open Publication No. 2003-223813

### SUMMARY OF THE INVENTION

### TECHNICAL PROBLEM

However, in the method disclosed in Patent Literature 1, it is still required to render the aluminum electrode layer 5 thinner to decrease an amount of the bow of the silicon semiconductor substrate. This is likely to cause the BSF effect to be reduced.

In addition, in the method disclosed in Patent Literature 2, since the multitude of fine pores are formed inside the electrode, a mechanical strength and an adhesion property of the aluminum electrode layer 5 are deteriorated.

Furthermore, in the method disclosed in Patent Literature 3, due to the inorganic compound powder, the adhesion property of the aluminum electrode layer 5 is deteriorated.

Accordingly, any method and any composition of the electrically conductive paste, which allow a desired BSF effect to be sufficiently attained and the amount of the bow to be reduced without deteriorating the mechanical strength and the adhesion property of the aluminum electrode layer 5, have not yet been developed.

Therefore, objects of the present invention are to solve the above-mentioned problems and to provide a paste composition capable of avoiding deteriorations in a mechanical strength and an adhesion property of an electrode layer, of sufficiently attaining a desired BSF effect, and of suppressing deformation (bow) of the silicon semiconductor substrate obtained after firing, even in a case where a silicon semiconductor substrate is rendered thin; and a solar cell element including an impurity layer, or an impurity layer and an electrode layer, which is (or are) formed by using the paste composition.

### SOLUTION TO PROBLEM

In order to solve the problems of the conventional art, the present inventors have devoted themselves to studies. As a result, the present inventors found that the above-mentioned objects can be achieved by using a paste composition having specific composition. Based on the findings, the paste composition according to the present invention has the following features.

A paste composition according to the present invention is used for forming an impurity layer or an electrode layer on a silicon semiconductor substrate and includes an aluminum-coated compound powder which aluminum-coated compound particles constitute. Each of the aluminum-coated compound particles includes: a compound-particle of at least one kind of a compound selected from the group consisting of an inorganic compound and an organic compound; and an aluminum-containing coating layer which covers a surface of the compound-particle, is located in an outermost surface of each of the aluminum-coated compound particles, and contains aluminum.

It is preferable that the paste composition according to the present invention further includes: at least one kind selected from the group consisting of an organic vehicle, a glass frit, and aluminum powder.

In addition, it is preferable that the paste composition according to the present invention includes the aluminum-coated compound powder of greater than or equal to 1.0% by mass and less than or equal to 90.0% by mass.

It is preferable that in the paste composition according to the present invention, an average particle diameter of the aluminum-coated compound particles is greater than or equal to 0.01 µm and less than or equal to 30.0 µm.

In addition, it is preferable that in the paste composition according to the present invention, an average thickness of the aluminum-containing coating layer is greater than or equal to 0.1 µm and less than or equal to 15.0 µm.

Furthermore, it is preferable that in the paste composition according to the present invention, each of the aluminum-coated compound particles constituting the aluminum-coated compound powder further includes a metal-containing interposing layer being interposed between the compound-particle and the aluminum-containing coating layer and containing metal other than aluminum.

A solar cell element according to one aspect of the present invention comprises at least an impurity layer formed by applying the paste composition having the above-described features onto a silicon semiconductor substrate and thereafter, conducting firing. In other words, the paste composition is applied onto the silicon semiconductor substrate and thereafter, the firing is conducted, thereby forming the impurity layer and the electrode layer, and thereafter, the electrode layer may be removed.

A solar cell element according to another aspect of the present invention comprises an impurity layer and an electrode layer which are formed by applying the paste composition having the above-described features onto a silicon semiconductor substrate and thereafter, conducting firing.

### ADVANTAGEOUS EFFECTS OF THE INVENTION

As described above, according to the present invention, by firing a silicon semiconductor substrate having applied thereto a paste composition including an aluminum-coated compound powder, even in a case where the silicon semiconductor substrate is rendered thin, not only a desired BSF effect which enhances an efficiency of collecting generated carriers can be attained and a mechanical strength and an adhesion property of the electrode can be maintained, but also deformation of the silicon semiconductor substrate obtained after firing can be reduced.

### BRIEF DESCRIPTION OF THE DRAWINGS

Fig. 1 is a schematic view showing a general sectional structure of a solar cell element.
Fig. 2 is a schematic diagram showing a method of measuring an amount of deformation of a silicon substrate obtained after firing.

### DESCRIPTION OF EMBODIMENTS

A paste composition according to the present invention is characterized in that the paste composition includes an aluminum-coated compound powder. Each of aluminum-coated compound particles constituting the aluminum-coated compound powder is characterized in that each of the aluminum-coated compound particles includes: a compound-particle of at least of one kind of a compound selected from the group consisting of an inorganic compound and an organic compound; and an aluminum-containing coating layer which covers a surface of the compound-particle, is located in an outermost surface of each of the aluminum-coated compound particles, and contains aluminum. The aluminum-containing coating layer may be formed of an aluminum alloy. The paste composition is caused to include the above-described aluminum-coated compound powder and such a paste composition is applied onto a silicon semiconductor substrate, thereby allowing suppression of deformation of the silicon semiconductor substrate obtained after firing.

Conventionally, as means for suppressing the deformation of the silicon semiconductor substrate obtained after firing, used are a means in which a powder composed of inorganic compound particles, organic compound particles, or carbon particles is added to a paste composition and a means in which a thickness of a coating film of a paste composition is rendered thin, and there is no substantially effective means other than these means. The addition of the powder composed of the inorganic compound particles, the organic compound particles, or the carbon particles has a certain effect in the suppression of the deformation of the substrate. However, the addition of the above-mentioned powder causes a problem that a mechanical strength and an adhesion property of an electrode layer are deteriorated. On the other hand, by rendering a thickness of a coating film of a paste composition thin, an amount of the deformation of the substrate is decreased. However, an amount of aluminum diffused from a surface of the silicon semiconductor substrate to an inside thereof becomes insufficient, and a desired BSF effect cannot be attained, thereby resulting in a problem that properties of a solar cell are deteriorated.

In contrast to these means, the present invention allows not only a desired BSF effect to be obtained but also the deformation of the silicon semiconductor substrate obtained after firing to be suppressed. Although the reason that the deformation of the silicon semiconductor substrate obtained after firing can be suppressed by causing the paste composition to include the above-mentioned aluminum-coated compound powder is not clear, it is considered that the reason may be that due to the presence of the compound particles constituting the aluminum-coated compound powder and/or the presence of particles carbonized during heating, amounts/an amount of shrinkage, which occurs upon cooling after the firing, of an impurity layer and/or an electrode layer which are/is formed upon the firing of the paste composition, are/is reduced.

In addition, it is also considered that in the present invention, since the aluminum-containing coating layer is located in the outermost surface of each of the aluminum-coated compound particles constituting the aluminum-coated compound powder, the deteriorations in the mechanical strength and the adhesion property of the aluminum electrode layer can be prevented owing to the mutual metallic bonding of the aluminum included in the aluminum-containing coating layer.

### [An aluminum-coated compound powder]

A content of the aluminum-coated compound powder used in the present invention; the aluminum-coated compound particles constituting the aluminum-coated compound powder; the compound particles as a base material of the aluminum-coated compound particles; and the aluminum-containing coating layer as the outermost layer of each of the aluminum-coated compound particles are not particularly limited. However, the below described are preferable.

### <A shape of each compound particle>

A shape of each of the compound particles is not particularly limited and may be of a spherical shape, a rod-like shape, a needle-like shape, a hollow-particle-shape, or other shape. In consideration of viscosity, thixotropy, application properties, and the like of the paste, it is more preferable that the shape of each of the compound particles is of the spherical shape.

### <Kinds of an inorganic compound used as a material of compound particles>

As an inorganic compound, an oxide, a hydroxide, a carbide, a nitride, and the like of metal or nonmetal, each of which has a thermal expansion coefficient smaller than that of aluminum (Al), are cited. For example, alumina, silica, mica, an aluminum hydroxide, a magnesium hydroxide, a silicon carbide, a silicon nitride, an aluminum nitride, a boron nitride, a calcium carbonate, a potassium titanate, and the like are cited. More preferably, as the inorganic compound, the alumina, the silica, the aluminum hydroxide, or the like, which allows a spherical powder to be industrially easily obtained, is used.

### < Kinds of an organic compound used as a material of compound particles>

As an organic compound, a polyester resin, a polyethylene resin, a polypropylene resin, a polybutene resin, an acrylic resin, an acrylonitrile resin, a urethane resin, an alkyd resin, a melamine resin, a polyvinyl alcohol, and the like, each of which has a thermal expansion coefficient smaller than that of aluminum (Al), are cited. It is preferable that the organic compound has heat resistance to a temperature greater than or equal to 200°C.

### <A content of an aluminum-coated compound powder>

It is preferable that a content of the aluminum-coated compound powder included in the paste composition according to the present invention is greater than or equal to 1.0% by mass and less than or equal to 90.0% by mass. It is more preferable that the content of the aluminum-coated compound powder is greater than or equal to 10.0% by mass and less than or equal to 85.0% by mass. It is further preferable that the content of the aluminum-coated compound powder is greater than or equal to 25.0% by mass and less than or equal to 80.0% by mass. If the content of the aluminum-coated compound powder is less than 1.0% by mass, a sufficient effect of the addition, which allows the deformation of the silicon semiconductor substrate obtained after firing to be suppressed, cannot be attained. On the other hand, if the content of the aluminum-coated compound powder exceeds 90.0% by mass, it is made difficult to render a composition in a paste state and application properties of a paste composition are likely to be deteriorated.

### <An average particle diameter of aluminum-coated compound particles>

It is preferable that an average particle diameter of the aluminum-coated compound particles included in the paste composition according to the present invention is greater than or equal to 0.01 µm and less than or equal to 30.0 µm. It is more preferable that the average particle diameter of the aluminum-coated compound particles is greater than or equal to 0.1 µm and less than or equal to 25.0 µm. It is further preferable that the average particle diameter of the aluminum-coated compound particles is greater than or equal to 0.5 µm and less than or equal to 20.0 µm. If the average particle diameter of the aluminum-coated compound particles exceeds 30 µm, formation of a p⁺ layer 7 which brings about the BSF effect becomes uneven and a sufficient energy conversion efficiency of a solar cell cannot be obtained. On the other hand, if the average particle diameter of the aluminum-coated compound particles is less than 0.01 µm, thixotropy of a paste composition is increased and application properties of the paste composition in screen printing or the like are likely to be deteriorated. Note that the average particle diameter can be measured by employing a laser diffraction-scattering method.

### <Formation of an aluminum-containing coating layer>

The aluminum-containing coating layer may be formed directly on a surface of each of the compound particles. However, as described later, an interposing layer of metal other than the aluminum may be interposed between the surface of each of the compound particles and the aluminum-containing coating layer, and on this metal-containing interposing layer, the aluminum-containing coating layer may be formed. In addition, in a case where the aluminum-containing coating layer is formed of an aluminum alloy, metallic elements other than the aluminum, which constitute the aluminum alloy, are not particularly limited, and it is only required for such metallic elements not to hamper the formation of the p⁺ layer 7 which brings about the BSF effect.

### <An average thickness of an aluminum-containing coating layers>

It is preferable that an average thickness of the aluminum-containing coating layers is greater than or equal to 0.1 µm and less than or equal to 15.0 µm. It is more preferable that the average thickness of the aluminum-containing coating layers is greater than or equal to 0.5 µm and less than or equal to 12.0 µm. It is further preferable that the average thickness of the aluminum-containing coating layers is greater than or equal to 1.0 µm and less than or equal to 10.0 µm. If the average thickness of the aluminum-containing coating layers is less than 0.1 µm, an amount of the aluminum becomes insufficient, the formation of the p⁺ layer 7 which brings about the BSF effect becomes insufficient, and an energy conversion efficiency of a solar cell is likely to be reduced. If the average thickness of the aluminum-containing coating layers exceeds 15.0 µm, because an average particle diameter of the aluminum-coated compound particles exceeds 30 µm, the formation of the p⁺ layer 7 which brings about the BSF effect becomes uneven and a sufficient energy conversion efficiency of a solar cell cannot be obtained. Note that the average thickness of the aluminum-containing coating layers can be measured in a manner such that 50 aluminum-coated compound particles are arbitrarily selected and a cross section of each of the selected aluminum-coated compound particles is observed by using an electron microscope.

### <A method of forming an aluminum-containing coating layer onto a surface of each of the compound particles>

A method of forming the aluminum-containing coating layer onto a surface of each of the compound particles is not particularly limited and is exemplified by the heretofore known method such as an evaporation method, a sputtering method, and a wet method. As the wet method, for example, the below-described method is cited.

First, on the surface of each of the compound particles, a metal-containing interposing layer which is a layer containing metal, such as copper (Cu), nickel (Ni), cobalt (Co), gold (Au), silver (Ag), palladium (Pd), tin (Sn), and the like, other than the aluminum is formed by employing an electroless plating method. Objects of this are to enhance an adhesion property between each of the compound particles and the aluminum-containing coating layer and to impart an electrically conducting property to each of the compound particles. On a surface of the metal-containing interposing layer, the aluminum-containing coating layer is formed by employing a molten salt plating method. Thus, the interposing layer of the metal other than the aluminum is caused to be present between the surface of each of the compound particles and the aluminum-containing coating layer.

### [An organic vehicle]

The paste composition according to the present invention may further include an organic vehicle as well as the aluminum-coated compound powder. As the organic vehicle, a vehicle obtained by dissolving ethyl cellulose, an acrylic resin, an alkyd resin, or the like in a solvent such as a glycol ether based solvent and a terpineol based solvent is used. It is preferable that a content of the organic vehicle is greater than or equal to 10% by mass and less than or equal to 90% by mass. If the content of the organic vehicle is less than 10% by mass or exceeds 90% by mass, printing properties of a paste composition are deteriorated. Note that the organic vehicle is added as a remainder of the paste composition in order to adjust a viscosity of the paste composition.

### [A glass frit]

Furthermore, the paste composition according to the present invention may further include a glass frit as well as the aluminum-coated compound powder or as well as the aluminum-coated compound powder and the organic vehicle. It is preferable that a content of the glass frit is less than or equal to 10.0% by mass. The glass frit is added in order to enhance an adhesion property between the aluminum-coated compound powder and the silicon semiconductor substrate 1 during the firing and to allow the p⁺ layer 7 as the impurity layer resulting from diffusion of aluminum atoms to be easily formed concurrently with the formation of an Al-Si alloy layer 6. If a content of the glass frit exceeds 10.0% by mass, segregation of glass is likely to occur. As the glass frit included in the paste composition according to the present invention, a B₂O₃-SiO₂- Bi₂O₃ based glass frit, a B₂O₃-SiO₂-ZnO based glass frit, a B₂O₃-SiO₂-PbO based glass frit, or the like in addition to a SiO₂-Bi₂O₃-PbO based glass frit is cited.

### [An aluminum powder]

Basically, it is only required for the paste composition according to the present invention to include the aluminum-coated compound powder. Even if the paste composition according to the present invention does not include an aluminum powder included in the conventional heretofore known paste composition, a desired BSF effect can be attained. More preferably, the paste composition according to the present invention may further include an aluminum powder as well as the aluminum-coated compound powder, or as well as the aluminum-coated compound powder and the organic vehicle, or as well as the aluminum-coated compound powder, the organic vehicle, and the glass frit. In this case, when an amount of the metal aluminum included in the aluminum-coated compound powder is insufficient with respect to an amount of metal aluminum, which is required to attain the desired BSF effect, the amount of the metal aluminum can be supplemented by adding the aluminum powder. It is preferable that a content of the aluminum powder is less than or equal to 70% by mass.

### EXAMPLES

Hereinafter, examples of the present invention will be described.

First, as shown in Table 1, kinds A, B, C, D, and E of aluminum-coated compound powders were prepared. The kinds A, B, C, D, and E of the aluminum-coated compound powders were prepared in a manner such that compound powders, each of which inorganic/organic compound particles shown in Table 1 constitute, were subjected to electroless plating processing, thereby forming metal-containing interposing layers, having thicknesses shown in Table 1, on surfaces of the inorganic/organic compound particles, and were further subjected to molten salt plating processing, thereby forming aluminum-containing coating layers, having thicknesses shown in Table 1, on surfaces of the metal-containing interposing layers. In the preparation of the kind C of the aluminum-coated compound powder, as a material of the aluminum-containing coating layer, an aluminum alloy of aluminum and 5% by mass of silicon was used. In addition, as described above, an average thickness of the aluminum-containing coating layers of each of the kinds A, B, C, D, and E of the aluminum-coated compound powders was measured in a manner such that 50 aluminum-coated compound particles of each of the kinds A, B, C, D, and E of the aluminum-coated compound powders were arbitrarily selected and a cross section of each of the selected aluminum-coated compound particles was observed by using an electron microscope.

Next, as shown in Table 2, examples 1 through 6 of paste compositions were prepared in a manner such that the paste compositions were caused to include: 30.0% by mass, 50.0% by mass, 60.0% by mass, or 65.0% by mass of any of the kinds A, B, C, D, and E of the aluminum-coated compound powders prepared as described above; 0% by mass or 5.0% by mass of the aluminum powder; 1.5% by mass or 3.0% by mass of a glass frit; and an organic vehicle as the remainder, and the above-mentioned components were mixed by using a well-known mixer.

As the organic vehicle, a vehicle obtained by dissolving ethyl cellulose in a glycol ether based solvent and as the glass frit, a B₂0₃-SiO₂-PbO based glass frit were used.

For comparison, a comparison example 1 of a paste composition was prepared in a manner such that components of 70.0% by mass of an aluminum powder, 1.5% by mass of the glass frit, and the organic vehicle as the remainder were mixed by using the well-known mixer. In addition, comparison examples 2 and 3 of paste compositions were prepared in a manner such that each of the paste compositions was caused to include: 3.0% by mass of an alumina (Al₂O₃) powder having an average particle diameter of 0.4 µm or 5.0% by mass of a carbon (C) powder having an average particle diameter of 5 µm, instead of the aluminum-coated compound powder; further, 70.0% by mass of the aluminum powder; 1.5% by mass of the glass frit; and the organic vehicle as the remainder, and the above-mentioned components were mixed by using the well-known mixer.

Here, as the aluminum-coated compound powders used in the paste compositions of the examples 1 through 6, in view of ensuring of reactivity with the silicon semiconductor substrate 1, application properties, and evenness of coating films, powders, each of which includes particles each having a spherical shape or a near-spherical shape whose average particle diameter is 0.5 through 10 µm, were used. The average particle diameters were measured by employing the laser diffraction-scattering method (apparatus name: Microtrac MT300EXII), as described above.

Each of the paste compositions prepared as described above was applied and printed onto the p-type silicon semiconductor substrate 1 having a thickness of 180 µm and a size of 155 mm × 155 mm by using a 250-mesh screen printing plate and was dried. An application amount was set in a manner such that an application thickness after drying was 15 through 30 µm.

After the p-type silicon semiconductor substrate 1 having the paste printed thereon was dried, firing was conducted under the condition that the p-type silicon semiconductor substrate 1 was heated in an air atmosphere in an infrared firing furnace at a heating rate of 400°C/minute and retained for 30 seconds at a temperature of 720°C. After the firing, a structure in which an aluminum electrode layer 5, an Al-Si alloy layer 6, and a p⁺ layer 7 were formed on the p-type silicon semiconductor substrate 1 as shown in Fig. 1 was obtained.

A surface resistance of a back side electrode 8 which exerts an influence on an ohmic resistance between electrodes was measured by using a four-probe type surface resistance measuring apparatus (RG-5 model sheet resistance measuring apparatus manufactured by NAPSON CORPORATION). Thereafter, the p-type silicon semiconductor substrate 1 having the back side electrode 8 formed thereon was immersed in a hydrochloric acid aqueous solution and the aluminum electrode layer 5 and the Al-Si alloy layer 6 were thereby dissolved to be removed, and a surface resistance of the p-type silicon semiconductor substrate 1 having the p⁺ layer 7 formed thereon was measured by using the above-mentioned surface resistance measuring apparatus. It is assumed that there is a correlation between a surface resistance of the p⁺ layer 7 and a BSF effect and the smaller the surface resistance, the higher the BSF effect. Here, a targeted value of a surface resistance of the back side electrode 8 is less than or equal to 24.0mΩ/sq. and a targeted value of a surface resistance of the p⁺ layer 7 is less than or equal to 22.0Ω/sq.

As shown in Fig. 2, an amount of the deformation of the silicon semiconductor substrate 1 obtained after firing was evaluated in a manner such that with the aluminum electrode layer 5 facing upward, one of the four corners of the substrate obtained after firing and cooling was pressed down and an amount x (including a thickness of the substrate) in which one corner located diagonally to the above-mentioned one of the four corners uplifted was measured. A targeted value of x is less than or equal to 2.3 mm.

A mechanical strength and an adhesion property of the aluminum electrode layer 5 formed on the silicon semiconductor substrate 1 was evaluated in a manner such that a cellophane adhesive tape was attached onto a surface of the aluminum electrode layer 5 and peeled off and whether or not the aluminum electrode layer 5 was peeled off was examined. In Table 2, o indicates that the aluminum electrode layer 5 was not peeled off at all, Δ indicates that a part of the aluminum electrode layer 5 was peeled off, and × indicates that the whole aluminum electrode layer 5 was peeled off.

The surface resistance of the back side electrode 8, the surface resistance of the p⁺ layer 7, and the amount of the deformation of the silicon semiconductor substrate 1 obtained after firing, and the peel property of the aluminum electrode layer 5, measured as described above, are shown in Table 2.

**[Table 1]**

| Powder kind | Inorganic/organic compound particles | Average particle diameter (µm) | Metal-containing interposing layer (Electroless plating) | Metal-containing interposing layer thicknness (nm) | Al-containing coating layer (Molten salt plating) | Al-containing coating layer thickness (µm) |
|---|---|---|---|---|---|---|
| A | Al₂O₃ | 0.5 | Ag | Approx.50 | Al | Approx. 1 |
| B | Al₂O₃ | 3.0 | Ag | Approx. 50 | Al | Approx.5 |
| C | Al₂O₃ | 3.0 | Ag | Approx. 50 | Al-5Si | Approx. 5 |
| D | SiO₂ | 0.5 | Ag | Approx. 50 | Al | Approx. 1 |
| E | Polyethylene | 5.0 | Ag | Approx. 50 | Al | Approx. 5 |

**[Table 2]**

| | | Kind of aluminum-coated compound powder | Added amount (% by mass) | Added amount of aluminum powder (% by mass) | Surface resistance of back side electrode (mΩ/sq.) | Surface resistance of p⁺ layer of Si substrate (Ω/sq.) | Deformation amount of Si substrate (mm) | Peel property of aluminum electrode layer | Added amount of glass frit (% by mass) | Added amount of vehicle (% by mass) |
|---|---|---|---|---|---|---|---|---|---|---|
| Example | 1 | A: Al₂O₃(Ag/Al) | 50.0 | - | 22.4 | 19.0 | 1.54 | ○ | 3.0 | Remainder |
| | 2 | B: Al₂O₃(Ag/Al) | 65.0 | - | 21.9 | 19.3 | 1.86 | ○ | 1.5 | Remainder |
| | 3 | B: Al₂O₃(Ag/Al) | 60.0 | 5.0 | 21.1 | 19.6 | 1.94 | ○ | 1.5 | Remainder |
| | 4 | C: Al₂O₃(Ag/Al-5Si) | 65.0 | - | 21.4 | 19.7 | 1.87 | ○ | 1.5 | Remainder |
| | 5 | D: SiO₂(Ag/Al) | 50.0 | - | 22.2 | 18.8 | 1.51 | ○ | 3.0 | Remainder |
| | 6 | E: Polyethylene (Ag/Al) | 30.0 | 5.0 | 22.5 | 19.3 | 1.99 | ○ | 1.5 | Remainder |
| Comparison example | 1 | Not added | - | 70.0 | 21.3 | 18.9 | 2.58 | ○ | 1.5 | Remainder |
| | 2 | Al₂O₃ powder (0.4 µm) | 3.0 | 70.0 | 22.8 | 19.2 | 1.94 | Δ | 1.5 | Remainder |
| | 3 | C powder (5 µm) | 5.0 | 70.0 | 23.6 | 19.0 | 2.21 | × | 1.5 | Remainder |

It is seen from the result shown in Table 2 that when the back side electrode 8 was formed by using each of the paste compositions (examples 1 through 6) according to the present invention, which included the aluminum-coated compound powder, it was made possible to reduce the amount of the deformation of the silicon semiconductor substrate 1 obtained after firing up to 2.3 mm or less, whereas when the back side electrode 8 was formed by using the conventional paste composition (comparison example 1), the amount of the deformation of the silicon semiconductor substrate 1 obtained after firing greatly exceeded 2.3 mm.

In addition, when the back side electrode 8 was formed by using each of the past compositions (comparison examples 2 and 3) which included the alumina powder and the carbon powder, though a certain degree of an effect of suppressing the amount of the deformation of the silicon semiconductor substrate 1 was observed, the adhesion property of the aluminum electrode layer 5 was deteriorated.

In contrast to these, when the back side electrode 8 was formed by using each of the paste compositions (examples 1 through 6) according to the present invention, which included the aluminum-coated compound powder, no deterioration in the adhesion property of the aluminum electrode layer 5 was observed.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

### INDUSTRIAL APPLICABILITY

When an impurity layer or an electrode is formed on a silicon semiconductor substrate constituting a crystalline silicon solar cell by using a paste composition according to the present invention and the silicon semiconductor substrate having applied thereonto the paste composition including an aluminum-coated compound powder is fired, even in a case where the silicon semiconductor substrate is rendered thin, not only a desired BSF effect which enhances an efficiency of collecting generated carriers can be attained and a mechanical strength and an adhesion property of the electrode can be maintained, but also deformation of the silicon semiconductor substrate obtained after firing can be reduced.

### REFERENCE SIGNS LIST

1: silicon semiconductor substrate, 2: n-type impurity layer, 3: antireflection film, 4: grid electrode, 5: aluminum electrode layer, 6: Al-Si alloy layer, 7: p⁺ layer, 8: back side electrode.

## Claims

1. A paste composition used for forming an impurity layer (7) or an electrode layer (5) on a silicon semiconductor substrate (1), comprising
an aluminum-coated compound powder being constituted of aluminum-coated compound particles, each of the aluminum-coated compound particles including: a compound-particle of at least one kind of a compound selected from the group consisting of an inorganic compound and an organic compound; and an aluminum-containing coating layer covering a surface of the compound-particle, being located in an outermost surface of each of the aluminum-coated compound particles, and containing aluminum.

2. The paste composition according to claim 1, further comprising at least one kind selected from the group consisting of an organic vehicle, a glass frit, and aluminum powder.

3. The paste composition according to claim 1, comprising the aluminum-coated compound powder of greater than or equal to 1.0% by mass and less than or equal to 90.0% by mass.

4. The paste composition according to claim 1, wherein an average particle diameter of the aluminum-coated compound particles is greater than or equal to 0.01 µm and less than or equal to 30.0 µm.

5. The paste composition according to claim 1, wherein an average thickness of the aluminum-containing coating layer is greater than or equal to 0.1 µm and less than or equal to 15.0 µm.

6. The paste composition according to claim 1, wherein each of the aluminum-coated compound particles constituting the aluminum-coated compound powder further includes a metal-containing interposing layer being interposed between the compound-particle and the aluminum-containing coating layer and containing metal other than aluminum.

7. A solar cell element comprising an impurity layer (7) formed by applying the paste composition according to claim 1 onto a silicon semiconductor substrate (1) and thereafter, conducting firing.

8. A solar cell element comprising an impurity layer (7) and an electrode layer (5) both formed by applying the paste composition according to claim 1 onto a silicon semiconductor substrate (1) and thereafter, conducting firing.
